Europäisches Patentamt

European Patent Office

Office européen des brevets

(19)

(11) Numéro de publication: **0 474 566 B1**

# FASCICULE DE BREVET EUROPEEN

(45) Date de publication du fascicule du brevet: **25.10.95**

(51) Int. Cl.[6]: **C30B 11/00**, C30B 29/22, C04B 35/00

(21) Numéro de dépôt: **91420288.2**

(22) Date de dépôt: **01.08.91**

(54) **Procédé de cristallisation en présence d'un champ magnétique.**

(30) Priorité: **02.08.90 FR 9010090**

(43) Date de publication de la demande:
**11.03.92 Bulletin 92/11**

(45) Mention de la délivrance du brevet:
**25.10.95 Bulletin 95/43**

(84) Etats contractants désignés:
**DE ES GB IT NL**

(56) Documents cités:
**EP-A- 0 358 049**
**US-A- 4 939 121**

**N.T.I.S. TECHNICAL NOTES, no. 4, partie H, avril 1986, page 438, Springfield,Virginia, US; NASA TECH. BRIEF: "Damping melt convention with a magnetic field"**

**JOURNAL OF CRYSTAL GROWTH, vol. 52, 1981, pages 524-529, Amsterdam, NL; A.E.MIKELSON et al.: "Control of crystallization processes by means of magnetic fields**

**PATENT ABSTRACTS OF JAPAN, vol. 13, no. 328 (C-621)[3676], 24 juillet 1989;& JP-A-1 108 156 (SUMITOMO) 25-04-1989**

(73) Titulaire: **CENTRE NATIONAL DE LA RECHER-CHE SCIENTIFIOUE (CNRS)**
**15, Ouai Anatole France**
**F-75700 Paris Cedex 07 (FR)**

(72) Inventeur: **Tournier, Robert**
**L'Archat**
**F-38850 Bilieu (FR)**

(74) Mandataire: **de Beaumont, Michel**
**1bis, rue Champollion**
**F-38000 Grenoble (FR)**

EP 0 474 566 B1

## Description

La présente invention concerne un procédé de cristallisation d'une substance en présence d'un champ magnétique. Elle s'applique de façon générale à toute substance présentant une anisotropie magnétique à l'état cristallin bien qu'elle soit décrite plus particulièrement ci-après dans le cadre de l'obtention de matériaux supraconducteurs à haute température tels que les matériaux de la famille RBaCuO où R est une terre rare telle que l'yttrium.

De nombreux auteurs ont déjà mentionné la possibilité et les avantages de l'application d'un champ magnétique pendant des phases de frittage pour améliorer l'orientation ou la dimension des grains cristallins que l'on cherche à obtenir.

Une partie des documents de l'art antérieur concerne l'amélioration de la cristallisation quand la substance que l'on cherche à obtenir est placée dans un milieu inhomogène. Un exemple de document de l'art antérieur traitant de ce sujet est l'article de A.E. Mikelson et al. paru dans Journal of Crystal Growth 52 (1981) pages 524-529. Dans cet article, on montre que, si on applique un champ de l'ordre de tesla à un alliage cadmium-zinc porté à l'état fondu, on obtiendra des dendrites de cadmium-zinc dans un alliage de composition différente, ces dendrites étant orientées selon les lignes de champ.

Dans d'autres articles, qui traitent plus particulièrement de l'obtention de supraconducteurs haute température, on propose de réaliser par frittage et compression un céramique supraconductrice puis d'opérer un recuit en présence d'un champ pour améliorer la structure cristalline de la céramique. Ainsi, dans la demande de brevet Européen 0 284 534, le premier exemple concerne la fabrication d'YBaCuO et l'on y traite de trois recuits successifs, le premier étant compris entre 500 et 1200 °C, par exemple 700 °C, le deuxième entre 500 et 1200 °C, par exemple 900 °C et le troisième entre 600 et 1200 °C, par exemple 800 °C. Ainsi, dans tous les exemples particuliers donnés, bien que la plage de température indiquée par l'auteur atteigne la température de fusion de YBaCuO (voisine de 1150 à 1200 °C), on reste en dessous de cette température et aucune différenciation n'est faite entre ce qui ce produit en dessous et au-dessus de la température de fusion.

La présente invention propose un procédé impliquant l'application d'un champ magnétique à substance en cours de cristallisation ou de recristallisation, dans lequel ce champ magnétique est appliqué lors que la composition de la substance est en phase liquide et comprend des cristallites susceptibles de servir de germes de cristallisation lors d'un refroidissement.

On montrera que la mise en oeuvre d'un tel procédé permet d'obtenir une composition polycristalline dont les grains sont bien mieux orientés que par les procédés classiques et notamment dans le cas où l'application d'un champ n'est pas effectuée en présence d'une phase liquide.

Avant d'exposer plus en détail la présente invention, on va rappeler quelques lois générales du magnétisme dont elle fait usage.

Les corps magnétiques présentent une susceptibilité magnétique $\chi$ que est généralement anisotrope. Par exemple, il existe des substances qui présentent un axe de facile aimantation appelé ci-après axe c, les deux autres axes étant les axes a et b. Ainsi, si $\chi$ est la susceptibilité magnétique, la différence de susceptibilité magnétique entre l'axe de facile aimantation (c) et les directions difficiles (a et b) s'écrit :

$$\Delta\chi = \chi_c - \chi_{ab}$$

Si l'on applique un champ magnétique, B, les particules tendent à s'orienter selon leur axe de facile aimantation et il se produit un gain d'énergie $\Delta E$ par rapport au cas d'une substance à répartition aléatoire des axes d'aimantation :

$$\Delta E = V \cdot B^2 \cdot \Delta\chi/2\mu_0$$

où V est le volume considéré et $\mu_0 = 4\pi \cdot 10^{-7}$ dans le système d'unités international.

Si l'on veut orienter un corps magnétique dans un champ, il faut que ce gain d'énergie $\Delta E$ soit nettement supérieur à l'énergie liée à l'agitation thermique, à savoir kT où T est la température absolue et k la constante de Boltzman.

Il résulte de cette comparaison, la définition de volumes ou domaines élémentaires susceptibles d'être orientés de façon satisfaisante. Par exemple, pour un grain de $YBa_2Cu_3O_7$ de 1 $\mu m^3$, qui constitue un supraconducteur à haute température, $\Delta\chi$ sera de l'ordre de $10^{-5}$ S.I. et l'on arrive à $\Delta E/kT = 10^4$ à T = 1500 °K et pour B = 5 teslas, c'est-à-dire $\Delta E \gg kT$. Par contre, $\Delta E/kT$ n'est plus égal qu'à 10 si la taille du grain tombe à $10^{-3}$ $\mu m^3$.

On considère ici seulement le cas le plus simple d'un anisotropie uniaxiale. Toutefois, il est connu que certaines substances magnétiques peuvent avoir plusieurs axes de facile aimantation équivalents ou même un plan de facile aimantation. Cette anisotropie magnétique peut être très élevée lorsque la substance est ordonnée magnétiquement et en particulier quand elle est ferromagnétique. Dans l'état paramagnétique, l'anisotropie magnétique est très faible mais souvent suffisante pour un alignement sous champ.

On rappellera que la susceptibilité magnétique $\chi$ varie comme l'inverse du carré de la température

$(1/T^2)$, c'est-à-dire que $\chi$ diminue rapidement quant T augmente.

La présente invention prévoit un procédé d'obtention d'un structure polycristalline texturée présentant à l'état cristallin une anisotropie magnétique comprenant les étapes consistant à préparer une composition telle qu'après passage à l'état fondu et solidification elle fournit sensiblement uniquement ladite substance et que, à la température de fusion de cette composition, il existe des cristallites de ladite substance ; chauffer lentement au voisinage de la température de fusion jusqu'à quelques degrés au-dessus de cette température, de sorte qu'il demeure des cristallites de ladite substance dans une phase liquide ; refroidir lentement au voisinage de la température de fusion, jusqu'à solidification ; et appliquer, au moins à partir du moment où la substance commence à entrer à l'état liquide jusqu'au moment où elle est à nouveau complètement solidifiée, un champ magnétique d'intensité suffisante pour conférer, nonobstant l'énergie d'agitation thermique, une orientation privilégiée aux cristallites de dimensions suffisantes pour constituer des germes de cristallisation.

Entre les étapes de chauffage et de refroidissement, peut être prévue une étape de maintien à température constante.

Selon une application de la présente invention, la substance est un supraconducteur haute température. Ce supraconducteur peut être du type RBaCuO où R désigne une terre rare.

Selon une application de la présente invention, pour l'obtention de $YBa_2Cu_3O_7$, ladite composition est un mélange en proportions stoechiométriques de $Y_2BaCuO_5$, $BaCuO_2$ et $CuO$ sous forme d'une poudre comprimée ; le chauffage est effectué entre 700 et 1040°C avec un gradient de température d'environ 100°C par heure, la composition étant maintenue à 1040°C pendant environ deux heures ; et le refroidissement est effectué à gradient d'environ 20°C par heure. Le champ magnétique est appliqué dès que la composition atteint la température d'environ 700°C et jusqu'à ce qu'elle repasse en dessous de cette température.

Il faut noter, que selon un aspect fondamental de la présente invention, l'étape de chauffage est réalisée de sorte que, au début de la phase de refroidissement, il existe des cristallites de la substance à obtenir de dimensions adaptées à constituer des germes de cristallisation.

Ceci implique que la température à laquelle on se place au dessus de la température de fusion ne doit pas être trop élevée pour que de tels germes ne disparaissent pas. En d'autres termes, il faut éviter toute surchauffe.

Ceci implique également que de tels germes existent initialement. Ainsi, dans des procédés où l'on part d'une composition comprenant un mélange stoechiométrique de précurseurs de la substance à obtenir, il faut que l'élévation en température avant la fusion proprement dite soit effectuée avec un gradient de température par rapport au temps suffisamment faible pour que de tels cristallites se créent.

Ceci implique aussi, par exemple dans le cas où l'on part d'une substance déjà cristallisée que l'on veut recristalliser, que l'élévation de température soit suffisante pour les cristallites de trop grande dimension "fondent" car, malgré la présence d'une phase liquide, ces cristallites trop gros pourraient se gêner mutuellement pour obtenir une orientation satisfaisante.

A partir du moment où l'on a choisi un processus thermique tel que l'on arrive à un état fondu dans lequel des cristallites de dimensions appropriées existent, il conviendra, d'après les formules exposées précédemment, de choisir une intensité de champ magnétique suffisante pour orienter ces germes nonobstant les phénomènes d'agitation thermique, c'est-à-dire que l'on doit avoir $\Delta E \gg kT$.

La présente invention va être décrite ci-après en relation avec des exemples de réalisation particuliers mais on notera dès maintenant que l'homme de l'art, étant donné les critères énoncés précédemment, pourra mettre en oeuvre ou texturer lors d'une phase de cristallisation ou de recristallisation.

La description ci-après, pour mieux expliquer les contraintes à satisfaire, indiquera d'une part des résultats d'expérience ne mettant pas strictement en oeuvre le procédé selon la présente invention et conduisant à des échecs et, d'autre part, un exemple d'expérience mettant en oeuvre la présente invention et conduisant à une texturation ou orientation convenable de grain de substance polycristalline.

Cette description sera faite en relation avec les figures jointes parmi lesquelles :

les figures 1 et 2 illustrent des courbes d'aimantation en fonction du champ pour des substances du type supraconducteur à haute température en milieu hétérogène ;

la figure 3 représente un chronogramme de température correspondant au procédé selon la présente invention appliqué à un corps du type YBaCuO ;

La figure 4 illustre une courbe d'aimantation en fonction du champ pour un corps du type YBaCuO ayant subi le procédé selon la présente invention ; et

la figure 5 représente une courbe d'aimantation en fonction du champ pour un corps de type YBaCuO qui a été porté à une température inférieure à sa température de fusion.

Avant d'exposer la présente invention, on va mentionner des expériences préliminaires réalisées par les inventeurs et destinées à illustrer la possibilité de texturation d'une substance de type RBaCuO en milieu hétérogène fondu en présence d'un champ magnétique. Bien que l'on appelle ici classiquement les corps considérés RBaCuO ou $RBa_2Cu_3O_7$, la formule exacte est $RBa_2Cu_3O_{7-\delta}$.

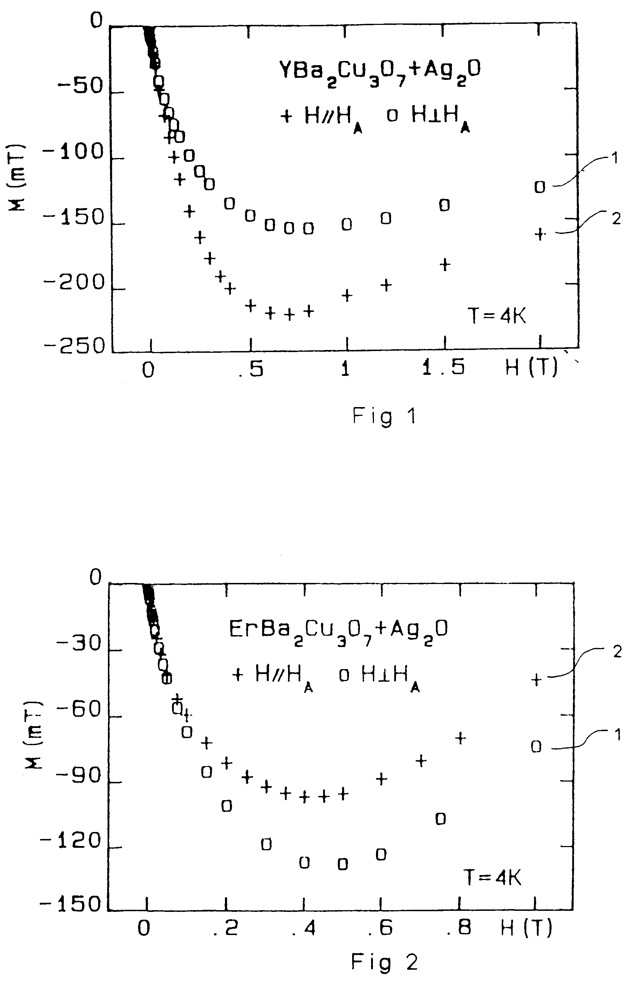

La demanderesse a fait subir à diverses poudres du type $RBa_2Cu_3O_7$ (où R désigne une terre rare) mélangées à de l'oxyde d'argent en poudre ($Ag_2O$), broyées et frittées, un traitement thermique jusqu'à une température voisine du point de fusion de la substance du type $RBa_2Cu_3O_7$ . A ces températures, $Ag_2O$ est à l'état liquide. Après un cycle thermique poursuivi jusqu'à environ 1020°C et un refroidissement à une vitesse de l'ordre de quelques dizaines de degrés par heure, on a effectivement obtenu une texturation du composite, c'est-à-dire que les grains de $RBa_2Cu_3O_7$ contenus dans le composite s'orientent selon une direction privilégiée. Plus particulièrement, si la terre rare est de l'yttrium, de l'holmium, du samarium ou de l'europium, l'axe c de la structure cristallographique des cristallites s'oriente parallèlement au champ appliqué car il est un axe de facile aimantation pour ses cristallites. Par contre, si c'est de l'erbium, l'axe c s'oriente perpendiculairement au champ appliqué car il est alors un axe de difficile aimantation tandis que le plan (a,b) est un plan de facile aimantation. L'apparition de cette anisotropie est illustrée par les figures 1 et 2 qui correspondent respectivement à un mélange d'$YBa_2Cu_3O_7$ et d'$Ag_2O$ et à un mélange d'$ErBa_2Cu_3O_7$ et d'$Ag_2O$. Les courbes des figures 1 et 2 illustrent l'aimantation M à 4 K en fonction du champ appliqué H. Dans chacune de ces figures, la courbe 1 correspond au cas où la champ de mesure est perpendiculaire à la direction du champ $H_m$ appliqué pendant le traitement et la courbe 2 au cas où le champ de mesure est parallèle au champ $H_m$ imposé pendant le traitement. Dans ces divers cas, les champs $H_m$ étaient de l'ordre de quelques teslas. Ces expériences préliminaires montrent que malgré la décroissance de la susceptibilité magnétique $\chi$ avec une augmentation de température, on peut pour des valeurs de champs raisonnables provoquer une orientation des cristallites de $RBa_2Cu_3O_7$ en milieu liquide à des températures aussi haute que 1020°C.

On va maintenant donner ci-après un exemple d'obtention de $YBa_2Cu_3O_7$ à partir de trois précurseurs, $Y_2BaCuO_5$, $BaCuO_2$ et $CuO$ en proportions stoechimétriques. On va montrer que, pour permettre une orientation en phase liquide, il faut suivre un processus opératoire approprié pour qu'il existe dans la phase liquide des cristallites de dimension adaptée du corps recherché ($YBa_2Cu_3O_7$).

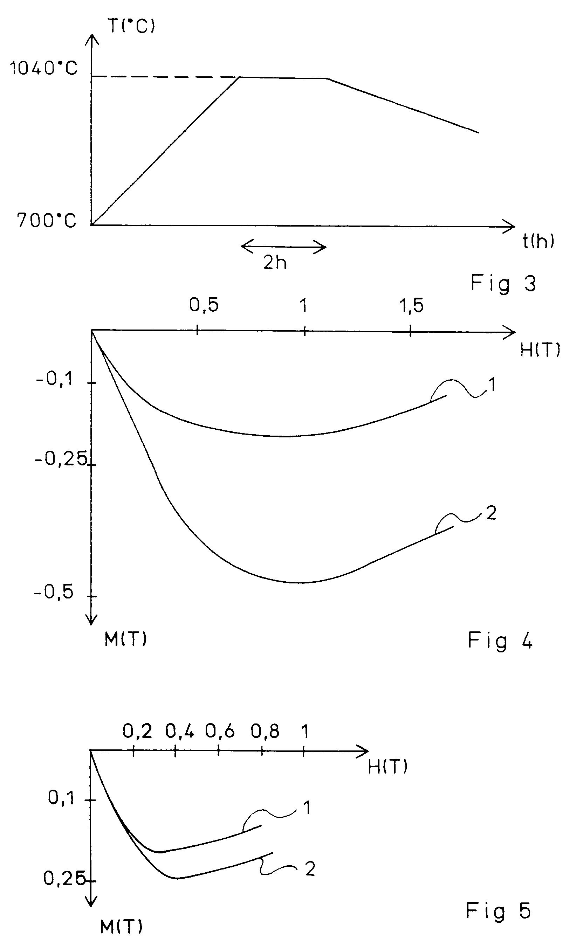

On part du mélange susmentionné préalablement fritté et on élève la température jusqu'à fusion (1040°C). Cette montée en température doit être suffisamment lente pour que les précurseurs réagissent en phase solide avant fusion pour former des cristallites (c'est ce qui se passe normalement dans le cas d'une opération de frittage). Par exemple, cette montée en température peut être effectuée à environ 100°C par heure entre 700 et 1040°C. Ensuite, comme le montre la figure 3, on maintient un palier à 1040°C pendant quelques heures, par exemple deux heures. Pendant la phase finale de montée en température et pendant le palier, un champ magnétique de quelques teslas, par exemple 7T, est appliqué. Après cela, on fait décroître doucement la température, à une vitesse de quelques degrés à l'heure, par exemple 20°C à l'heure. Le champ magnétique demeure appliqué jusqu'à solidification et peut être maintenu en deçà. On observe alors, comme le montre la figure 4, que l'on a obtenu une céramique de $YBa_2Cu_3O_7$ présentant une anisotropie quasi totale, c'est-à-dire une substance dont les grains cristallins sont orientés parallèlement les uns aux autres, l'axe c étant parallèle à la direction du champ magnétique appliqué pendant la phase à haute température. Les résultats indiqués par la figure 4 sont très nettement confirmés par des analyses spectrales aux rayons X.

Une expérience similaire ou la température maximale était de 1050°C et le champ de 5 T a donné une céramique de $YBa_2Cu_3O_7$ orientée (orientation légèrement perturbée par des inhomogénéités de température dans le creuset pendant le refroidissement) et avec des courants critiques quatre fois plus élevés que dans l'exemple précédent.

Ensuite, diverses expériences ont été menées par les inventeurs pour montrer les limites du procédé.

La figure 5, qui est illustrative d'une expérience similaire à celle de la figure 3 mais dans laquelle la température maximale était de 1020°C, montre que l'on obtient du $YBa_2Cu_3O_7$ à faible anisotropie quand on n'est pas nettement passé dans l'état liquide.

Toujours avec un palier à 1020°C mais en prolongeant ce palier de 24 heures, on n'obtient pas de résultat détectable aux rayons X.

Un palier à 1030°C conduit à des résultats tout aussi négatifs.

Dans une autre expérience, on a suivi le même processus que celui illustré par la figure 3 mais la vitesse de montée en température était de 200°C par heure au lieu de 100°C par heure et la température maximale était de 1050°C. On a alors obtenu du $YBa_2Cu_3O_7$ non texturé dans la direction du champ magnétique. L'interprétation de cette expérience est que, dans ce cas, les cristallites n'avaient pas eu le temps de se former en phase solide à une taille suffisante et qu'en raison de la température élevée du liquide, les cristallites ont été "dissoutes" et qu'elles ont alors atteint des dimensions trop faibles pour pouvoir servir de germes de cristallisation uniformément répartis dans la phase liquide.

Une autre expérience a été menée dans laquelle la température maximale était de l'ordre de 1055 °C. A nouveau, les résultat final a été une absence d'anisotropie liée à la présence du champ magnétique. Ceci s'explique par le fait que, en raison de la température trop élevée de la phase liquide (surchauffe), les cristallites ont, comme précédemment, été "dissoutes".

Des expérience concordante ont été effectuées en partant de précurseurs chimiques de $HoBa_2Cu_3O_7$ élevé à sa température de fusion.

En conclusion, il apparaît qu'il faut respecter au moins deux contraintes pour une mise en oeuvre du procédé selon la présente invention, la première contrainte étant qu'il existe des germes au moment où l'on arrive en phase liquide, la deuxième contrainte étant que ces germes ne soient pas éliminés par une augmentation de température excessive ou une durée excessive de traitement en phase liquide.

Par ailleurs, la demanderesse a réalisé diverses expériences conformes à l'état de la technique dans lesquelles le champ magnétique a été appliqué alors que l'on se trouve bien en dessous de la phase liquide. Ces expériences n'ont pas donné de résultat concluant quant à une variation nette de l'anisotropie de la céramique obtenue. Tout au plus, des améliorations de l'ordre de quelques pour cent (10 à 15 %) et non pas une anisotropie de pratiquement 100 % comme celle qui est obtenue par la présente invention.

On a indiqué ci-dessus les résultats d'une succession d'expériences effectuées par la demanderesse, essentiellement sur des supraconducteurs haute température du type $RBa_2Cu_3O_7$, et plus particulièrement des expériences dans lesquelles ce supraconducteur haute température était obtenu à partir de précurseurs en mélange stoechiométrique. La présente invention s'applique également au cas où l'on part directement de la substance finale que l'on cherche à obtenir à condition de se placer au-dessus de la température de fusion qui n'est pas la même que celle du mélange de précurseurs. Par exemple, pour $YBa_2Cu_3O_7$, la température de fusion est très supérieure à 1050 °C au lieu de 1040 °C pour le mélange de précurseurs. Toutefois, la fusion ne produit pas de liquide sans embryons solides et il demeure jusqu'à des températures légèrement supérieures à la température de fusion (quelques degrés, jusqu'au 10 à 15 degrés), des cristallites susceptibles de former des germes et permettant donc de mettre en oeuvre l'invention, ou bien de tels germe croissent au cours du processus de solidification.

En outre, des substances complètement différentes de celles qui ont servi de base aux exemples ci-dessus peuvent également être texturées (orientées cristallographiquement) par le procédé selon la présente invention du moment qu'elles présentent une anisotropie magnétique.

En outre, il est connu que, pour faciliter la solidification d'un corp selon son axe ou son plan de croissance favorisé, il est souhaitable d'appliquer, lors du refroidissement, un gradient de température dans la direction de cet axe ou de ce plan de croissance. En pratique, ceci signifie que, étant donné un corps en cours de solidification, on appliquera éventuellement un gradient de température favorisant la développement de la croissance dans le sens déjà imposé par la champ magnétique appliqué selon l'invention.

Ainsi, étant donné par exemple un barreau ou un fil d'$YBa_2Cu_3O_7$ comprenant une zone fondue soumise à un champ magnétique transverse par rapport à la direction du barreau, le gradient de température longitudinal favorise la texturation le long du barreau ou fil.

## Revendications

1. Procédé d'obtention d'une substance polycristalline texturée, présentant à l'état cristallin une anisotropie magnétique, caractérisé en ce qu'il comprend les étapes suivantes :

préparer une composition telle qu'après passage à l'état fondu et solidification elle fournit sensiblement uniquement ladite substance et que, à la température de fusion de cette composition, il existe des cristallites de ladite substance ;

chauffer lentement au voisinage de la température de fusion jusqu'à quelques degrés au-dessus de cette température, de sorte qu'il demeure des cristallites de ladite substance dans une phase liquide ;

refroidir lentement au voisinage de la température de fusion, jusqu'à solidification ; et

appliquer, au moins à partir du moment où la substance commence à entrer à l'état liquide jusqu'au moment où elle est à nouveau complètement solidifiée, un champ magnétique d'intensité suffisante pour conférer, nonobstant l'énergie d'agitation thermique, une orientation privilégiées aux cristallites de dimensions suffisantes pour constituer des germes de cristallisation.

2. Procédé selon la revendication 1, caractérisé en ce qu'il comprend, entre les étapes de chauffage et de refroidissement, une étape de maintien à température constante.

3. Procédé selon la revendication 1, caractérisé en ce que ladite substance est un supraconducteur haute température.

4. Procédé selon la revendication 3, caractérisé en ce que ladite substance est un supraconducteur du type RBaCuO où R désigne une terre rare.

5. Procédé selon la revendication 4, pour l'obtention de $YBa_2Cu_3O_7$, caractérisé en ce que :

   ladite composition est un mélange en proportions stoechiométrique de $Y_2BaCuO_5$, $BaCuO_2$ et $CuO$ sous forme d'une poudre comprimée ;

   le chauffage est effectué entre 700 et 1040°C avec un gradient de température d'environ 100°C par heure, la composition étant maintenue à 1040°C pendant environ deux heures ; et

   le refroidissement est effectué à un gradient d'environ 20°C par heure.

6. Procédé selon la revendication 5, caractérisé en ce que le champ magnétique est appliqué dès que la composition atteint la température d'environ 700°C jusqu'à ce qu'elle repasse en dessous de cette température.

## Claims

1. A method for preparing a textured polycrystalline material having, in the crystalline state, a magnetic anisotropy, characterized in that it comprises the following steps:

   preparing a compound such that, after being molten and solidified, it provides substantially only said material and that, at the melting temperature, crystallites of said material exist;

   slowly heating close to the melting temperature, up to some degrees above said temperature, so that it remains crystallites of said material in a liquid phase;

   slowly cooling close to the melting temperature, up to solidification; and

   applying, at least from the time at which the material begins to enter the liquid state up to the time at which it is again fully solidified, a magnetic field having a sufficient strength to preferentially orient, despite the thermal agitation energy, crystallites having a sufficient size for constituting crystallization seeds.

2. A method according to claim 1, characterized in that it comprises, between the heating and cooling steps, a step corresponding to a constant temperature level.

3. A method according to claim 1, characterized in that said material is a high temperature superconductor.

4. A method according to claim 3, characterized in that said material is a superconductor of the RBaCuO type where R designates a rare earth element.

5. A method according to claim 4, for preparing $YBa_2Cu_3O_7$, characterized in that:

   said compound is a stoichiometric mixture of $Y_2BaCuO_5$, $BaCuO_2$ and $CuO$ in the form of a pressed powder;

   the heating is carried out between 700 and 1040°C with a temperature gradient of about 100°C per hour, the compound being maintained at 1040°C for about two hours; and

   the cooling is carried out with a gradient of about 20°C per hour.

6. A method according to claim 5, characterized in that the magnetic field is applied as soon as the compound attains the temperature of about 700°C and as long as it is above said temperature.

## Patentansprüche

1. Verfahren zum Herstellen eines strukturierten polykristallinen Materials, das in dem kristallinen Zustand eine magnetische Anisotropie besitzt, dadurch **gekennzeichnet,** daß das Verfahren die folgenden Schritte aufweist:

   Herstellen einer Verbindung, so daß, nachdem sie geschmolzen und verfestigt ist, sie im wesentlichen nur das Material vorsieht und daß bei der Schmelztemperatur Kristallite des Materials auftreten;

   langsames Erwärmen in der Nähe der Schmelztemperatur, bis auf einige Grad über dieser Temperatur, so daß Kristallite des Materials in einer Flüssigphase verbleiben;

   langsames Abkühlen in der Nähe der Schmelztemperatur bis zur Verfestigung; und

   Anlegen mindestens von der Zeit an, in der das Material anfängt in den Flüssigzustand einzutreten bis zu der Zeit, bis es vollständig verfestigt ist, eines Magnetfeldes mit einer ausreichenden Stärke, um Kristallite mit einer ausreichenden Größe zum Bilden von Kristallisierungskeimen oder -kernen zu orientieren, und zwar trotz der thermischen Agitationsenergie.

2. Verfahren nach Anspruch 1, dadurch gekennzeichnet, daß es zwischen den Erwärmungs- und Kühlschritten einen Schritt aufweist, der einem konstanten Temperaturniveau entspricht.

3. Verfahren nach Anspruch 1, dadurch gekennzeichnet, daß das Material ein Hochtemperatursupraleiter ist.

4. Verfahren nach Anspruch 3, dadurch gekennzeichnet, daß das Material ein Supraleiter des RBaCuO-Typs ist, wobei R ein Seltenerdelement bezeichnet.

5. Verfahren nach Anspruch 4 zur Herstellung von $YBa_2Cu_3O_7$, dadurch gekennzeichnet, daß:
die Verbindung eine stöchiometrische Mischung aus $Y_2BaCuO_5$, $BaCuO_2$ und $CuO$ ist, und zwar in der Form eines gepreßten Pulvers; wobei das Erwärmen zwischen 700 und 1040 °C ausgeführt wird, und zwar mit einem Temperaturgradienten von ungefähr 100 °C pro Stunde, wobei die Verbindung bei 1040 °C gehalten wird, und zwar für ungefähr 2 Stunden; und
wobei die Kühlung mit einem Gradienten von ungefähr 20 °C pro Stunde durchgeführt wird.

6. Verfahren nach Anspruch 5, dadurch gekennzeichnet, daß das Magnetfeld angelegt wird, sobald die Verbindung die Temperatur von ungefähr 700 °C erreicht und so lange wie sie über dieser Temperatur ist.

Fig 1

Fig 2

Fig 3

Fig 4

Fig 5